# EUROPEAN PATENT SPECIFICATION

(11) **EP 2 988 580 B1**
(45) Date of publication and mention of the grant of the patent: **11.10.2017**
(21) Application number: 14181873.2
(22) Date of filing: 22.08.2014
(51) Int. Cl.: H05K 7/20, E21B 41/00

(54) **A subsea unit enclosing an electrically insulating liquid and a thermally conducting liquid**
Unterwassersystemeinheit mit Umschließung einer elektrisch isolierenden Flüssigkeit und einer thermisch leitenden Flüssigkeit
Unité sous-marine renfermant un liquide électriquement isolant et un liquide thermiquement conducteur

(43) Date of publication of application: 24.02.2016
(73) Proprietor: ABB Schweiz AG, 5400 Baden (CH)
(72) Inventor: Herland, Oddvar, NO-5264 Garnes (NO); Bolgiani, Fabio, CH-5242 Lupfig (CH); Gradinger, Thomas, 5032 Aarau Rohr (CH); Wagner, Thomas, 5506 Mägenwil (CH); Cagienard, Raphael, 5430 Wettingen (CH); Zuckerberger, Adrian, 5417 Untersiggenthal (CH)
(74) Representative: Savela, Reino Aleksi

(56) References cited:
- EP-A1- 2 487 327
- WO-A1-2014/071985
- GB-A- 2 342 713
- US-A- 3 200 881

## Description

### TECHNICAL FIELD

The present disclosure generally pertains to subsea installations and in particular to a subsea unit, primarily a subsea converter, comprising a heat generating component which is to be cooled. In this disclosure the term "subsea" is intended to specify a region close to the seabed at great depths, at least 1000 m. Such a region can also be defined as "deepwater subsea".

### BACKGROUND

In recent years, there has been a growing interest in electrical installations on the seabed at great depths. Typically, power electronics for subsea use have been enclosed in vessels filled with electrically insulating oil. Cooling of the electronics has been achieved by either natural convection or forced circulation of the oil, which oil in turn transfers the heat from the components to the surrounding sea water.

In the prior art subsea installation publication WO2008055515 A1, a main vessel is filled with oil and contains a housing, which is also filled with oil. The differential pressures between the surrounding seawater and the interiors of the housing and the main vessel are negligible. Waste heat rising at a converter inside the housing is dissipated via the two oils to the seawater.

EP2487327 A1 discloses a subsea electronic system comprising a pressure compensated enclosure filled with a dielectric liquid and containing a heat generating component. In operation, heat is transferred from the heat generating electronic component to the water surrounding the enclosure via the dielectric liquid.

US 2012/033928 A1 discloses a subsea unit comprising a pressure vessel arranged to withstand ambient sea water pressure at sea ground of at least 50 bar, and to keep up an internal pressure that is closer to atmospheric pressure than sea water pressure at the sea ground, a first type of electric component, and a two-phase cooling system arranged to cool the first type of electric component. The two-phase cooling system comprises: a first cooling fluid, a first evaporator arranged within the pressure vessel, wherein the first evaporator is arranged in thermal connection with the first type of electric component, a condenser arranged outside the pressure vessel to allow the condenser to be in thermal connection with sea water, a vapour conduit arranged to transfer first cooling fluid from the first evaporator towards the condenser, and a liquid conduit arranged to transfer first cooling fluid from the condenser towards the first evaporator. The first evaporator, the condenser, the vapour conduit and the liquid conduit form a closed loop for circulating the first cooling fluid in the two-phase cooling system.

US6867364 B2 discloses a subsea transformer and distribution unit comprising first and second chambers, which are filled with oil and pressure compensated. A transformer is arranged in the first chamber where it is cooled by the oil which in turn is cooled by the surrounding water mass.

EP1310759 B1 discloses a subsea power equipment comprising a pressure vessel having a first chamber containing a heat-producing power device and a second chamber at least partially filled with a fluid such as water, methyl alcohol or a proprietary refrigerant. Heat from the power devise is conducted through the fluid in the second chamber and is dissipated into the surrounding water.

### SUMMARY OF THE INVENTION

Prior art solutions suffer from various drawbacks. Typically, subsea heat generating components are positioned in either a dielectric liquid or in a dielectric gas. The liquid or gas shall provide not only electrical insulation but also cooling, by transferring heat from the components to the surrounding sea water. The liquid or gas can be chosen either based on its electrical insulating properties or on its heat transfer properties, and therefore a compromise between these properties is inevitable.

Dielectric gases typically suffer from relatively poor heat transfer ability, wherefore electrical components arranged in dielectric gas may potentially be overheated in use. Furthermore, a gas-filled subsea unit need very thick walls in order to resist the outer pressure. Dielectric liquids are often viscous at lower temperatures (close to 0 °C) and can therefore when cold not transfer heat by means of convection. Dielectric liquids may therefore offer poor cooling at start-up, or in the vicinity of an outer wall which is cooled by the surrounding water.

A general object of the present disclosure is to provide a subsea unit that ensures efficient cooling of heat generating components in a passive way at all times of operation. The cooling shall function efficiently shortly after start-up of the subsea unit and also provide powerful cooling at steady state operation, while little space is needed for the cooling arrangement.

According to the present invention, this object is solved by a subsea unit comprising a component reservoir containing a heat generating component and a first liquid, and a cooling reservoir containing a second liquid and being arranged in thermal conductive connection with the component reservoir. The first liquid is one which has suitable electrical insulating properties in order to electrically insulate the heat generating component and the second liquid is one which has suitable heat transfer properties in order to provide cooling to the component reservoir.

In this way, the heat generating component can be surrounded by a first liquid of optimal electrically insulating properties, i.e. of very high electrically insulating properties. Using such a first liquid, the component reservoir can be very compact, while a proper electrical insulation of the component is still ensured. Since the component reservoir is in thermal conductive connection with the cooling reservoir, heat is transferred to the cooling reservoir by means of conduction, convection and radiation. Thermal conductive connection can also be denoted direct thermal contact. As the component reservoir can be made compact, the distance between the component and the cooling reservoir can be kept to a minimum. The first liquid will also be quickly heated throughout the compact component reservoir at start-up, quickly reducing the viscosity of the first liquid.

Meanwhile, the cooling reservoir can be furnished with a second liquid of optimal heat transfer properties. Desired thermal properties of the second liquid include high thermal conductivity and high specific heat. By means of the second liquid of optimal heat transfer properties, the heat from the component reservoir is effectively transported to the surrounding sea water. The second liquid is preferably one of low viscosity, especially one of low viscosity at lower temperatures (close to or below 0 °C), ensuring efficient cooling also at start-up. Preferably, the dynamic viscosity of the cooling liquid is lower than 2 mPa·s at 5 degrees Celsius. Further, the second liquid can preferably be one of high thermal expansion coefficient, which has a positive effect on the convective flow of the second liquid. Preferably, the volumetric thermal expansion coefficient (αᵥ) of the cooling liquid is at least 3·10⁻²/K at 40 degrees Celsius.

In a typical example, the second liquid will have better heat transfer properties, i.e. higher thermal conductivity and higher specific heat, than the first liquid. The thermal conductivity of the second liquid may be at least 5 times as high as the thermal conductivity of the first liquid. The specific heat of the second liquid may be at least 2 times as high as the specific heat of the first liquid. Also, the first liquid will typically have better electrical insulating properties, i.e. higher electrical resistivity, than the second liquid. The second liquid may be electrically conducting.

Preferably, the second liquid has a thermal conductivity of at least 0.5 W/(m·K). Preferably, the second liquid has a specific heat of at least 4000 J/(kg·K). The corresponding values for the first liquid are approximately 0.1 W/(m·K) and 2000 J/(kg·K). These values may vary with temperature, the values above apply at 40 degrees Celsius.

The second liquid may mainly consists of non-deionized water. By "mainly" is meant that more than 50 % by weight of the second liquid may is non-deionized water. The rest may by additives in form of corrosion inhibitors and/or anti-freezing agents. When installed subsea, normally on the seabed, the unit will not be exposed to temperatures below zero, but during transport this may very well be the case. By non-deionized water is meant fresh water or normal tap water, which to a certain degree is electrically conducting. The second liquid may also be distilled water.

The present invention, with separate component and cooling reservoirs, allows for the cooling reservoir to be free from electric and electronic equipment.

The first liquid may be transformer oil, ester, purified water or a combination thereof. One example of a suitable oil is 'Nytro 10XN'.

In order to keep the outer surface temperature of the subsea unit low, thereby preventing growth of sea life and scale deposit on the outer surface, the component reservoir may be arranged out of thermal conductive connection with all outer walls of the unit. The component reservoir may be completely surrounded by the second liquid of the cooling reservoir. Then, all heat from the component reservoir will be transferred to and through the cooling reservoir and then be dissipated to the surrounding water. The heat will chiefly be transferred to the surrounding water by convection.

It should be noted that there may be thermally conductive elements in form of electrical wiring and mechanical support means running from the component reservoir to the outer walls of the subsea unit. Therefore, the component reservoir may not be arranged completely out of thermal conductive connection with all outer walls of the unit. This could be expressed as the component reservoir being arranged out of essential thermal conductive connection with all outer walls of the unit.

Alternatively, in order to increase the cooling efficiency, the component reservoir may be arranged in thermal conductive connection with an outer wall of the subsea unit. This way, heat from the component reservoir will be transferred directly, i.e. not through the cooling reservoir, to the surrounding water by means of conduction, convection and radiation.

In order to keep the outer surface temperature of the subsea unit low, the subsea unit could be configured such that no heat generating component is arranged in thermal conductive connection with an outer wall of the subsea unit. At the same time, the component reservoir may be arranged out of thermal conductive connection with all outer walls of the unit.

The heat generating component may be arranged in thermal conductive connection with the cooling reservoir in order to improve the heat dissipation from the heat generating component to the cooling reservoir. This may mean that the heat generating component is attached to a wall of the cooling reservoir.

The dissipation of heat from the heat generating component out of the component reservoir can be improved by arranging the heat generating component in thermal conductive connection with an outer wall of the component reservoir. The heat from the component will then be efficiently conducted through the outer wall of the component reservoir. There may be arranged an electrically insulating, yet thermally conducting, layer between the heat generating component and wall of the component reservoir. Such a layer allows the heat generating component and the wall to be at different electrical potentials.

Alternatively, the subsea unit may be configured such that no heat generating component is arranged in thermal conductive connection with an outer wall of the component reservoir. Thereby, the first liquid will be particularly quickly heated at start-up.

The cooling reservoir may contain an inner heat exchanging device arranged in thermal conductive connection with the heat generating component in order to promote the heat transfer from the heat generating component to the second liquid. An example of such a heat exchanging device is a passive heat exchanger in the form of a heat sink. The heat sink is preferably designed to maximize its surface area in contact with the second liquid. The heat sink may be a metal body provided with fins which are surrounded by the second liquid, or provided with channels through which the second liquid flows in use. The heat generating component is arranged in thermal conductive connection with the metal body. Suitable metals for the inner heat exchanging device include aluminium and copper. There may be arranged an electrically insulating, yet thermally conducting, layer between the heat generating component and the metal body.

The cooling reservoir may be loop-shaped in order to promote a convective flow of the second liquid in use. Such a flow can be referred to as a cyclic convective flow along the loop. A loop-shaped configuration may be one where the cooling reservoir is of tubular cross-section and forms a closed circuit. The cooling reservoir may pass through the component reservoir, so that heat is effectively dissipated from the first liquid to the second liquid. The heat generating component may be arranged in thermal conductive connection with the cooling reservoir, improving the heat transfer from the heat generating component to the cooling reservoir. There may be arranged an electrically insulating, yet thermally conducting, layer between the heat generating component and the cooling reservoir.

The cooling reservoir may comprise an outer heat exchanging device which is arranged in direct contact with the water surrounding the subsea unit. In this way, the heat transfer from the second liquid to the surrounding water may be improved. The outer heat exchanging device may be a heat exchanger, such as a bundle of tubes through which the second liquid flows, which tubes are surrounded by the surrounding water.

The inner heat exchanging device transfers heat from a solid element to a liquid, namely from the heat generating component to the second liquid. The outer heat exchanging device transfers heat from one liquid to another liquid, namely from the second liquid to the surrounding water.

When an outer heat exchanging device is comprised in the subsea unit, said outer heat exchanging device is preferably arranged vertically higher than the component reservoir. By means of such a configuration, the convective flow of the second liquid is further promoted. More precisely, the centre of gravity of the volume of the second liquid within the outer heat exchanging device is arranged vertically higher than the centre of gravity of the volume of the first liquid within component reservoir.

When both outer and inner heat exchanging devices are comprised in the subsea unit, the outer heat exchanging device is preferably arranged vertically higher than the inner heat exchanging device. More precisely, the subsea unit is configured such that the centre of gravity of the volume of the second liquid within the outer heat exchanging device is arranged vertically higher than the centre of gravity of the volume of the second liquid within the inner heat exchanging device.

Preferably, the component reservoir is pressure compensated. This can be obtained by filling the component reservoir with the first liquid and furnishing the component reservoir with a pressure compensating device or by connecting it to a pressure compensating device. The cooling reservoir is preferably also pressure compensated, by being filled with the second liquid and being furnished with or connected to a pressure compensating device. A pressure compensating device e.g. may be a flexible wall portion or a bellows structure. Pressure compensated reservoirs will have an inner pressure that corresponds to the outer pressure, there may be a negligible pressure difference due to mechanical resistance of the pressure compensating device. If a bellows structure is employed, such a pressure difference may amount to approximately 0.3 bar. The reservoirs are preferably completely filled with their respective liquids.

A pressure compensated subsea reservoir allows efficient heat transfer since the reservoir does not need a thick wall in order to resist the high pressure at the seabed, which may amount to hundreds of bard, e.g. 300 bar or more. The pressure inside the reservoir is substantially equivalent to the pressure of the surrounding water. Typically, the walls of the reservoirs are made of relatively thin and heat conductive metal, e.g. 10 mm steel or aluminium.

The configuration of the subsea unit described above is particularly suitable for a subsea converter. The heat generating component may be an insulated-gate bipolar transistor.

According to the present invention, the object initially mentioned is also is solved by the use of the subsea unit as described in different examples above in a deepwater subsea environment, at a depth greater than 1000 m.

### BRIEF DESCRIPTION OF THE DRAWINGS

Specific examples of the invention will now be described with reference to the accompanying drawings, in which
figure 1 is a schematic side view of a subsea unit 10 where a component reservoir 40 is filled with a first liquid 30 which completely surrounds a heat generating component 60, said component reservoir 40 is in turn arranged within a cooling reservoir 20 and is completely surrounded by a second liquid 30 which fills the cooling reservoir 20;
figure 2 shows a similar unit 10a but where the component reservoir 40 is in thermal conductive connection with a wall of the cooling reservoir 20;
figure 3 shows unit 10b similar to that of figure 1 but where the heat generating component 60 is in thermal conductive connection with a wall of the component reservoir 40;
figure 4 is a schematic side view of a subsea unit 10c having a component reservoir 40 and a cooling reservoir 20 principally comparable to what is shown in figure 1, but where said reservoirs 40, 20 are arranged side by side;
figure 5 shows a unit 10d similar to that of figure 4 but with the addition of an optional inner heat exchanging device 70 and an optional second heat generating component 80;
figure 6 is a schematic side view of a subsea unit 10e having a component reservoir 40 and a cooling reservoir 20 principally comparable to what is shown in figure 1, but where the cooling reservoir 20 is loop-shaped and runs through the component reservoir 40;
figure 7 shows a subsea unit 10f similar to that of figure 6 but with the addition of an optional outer heat exchanging device 90; and
figure 8 shows a subsea unit 10g similar to that of figure 6 but with optional inner 70 and outer 90 heat exchanging devices.

### DETAILED DESCRIPTION

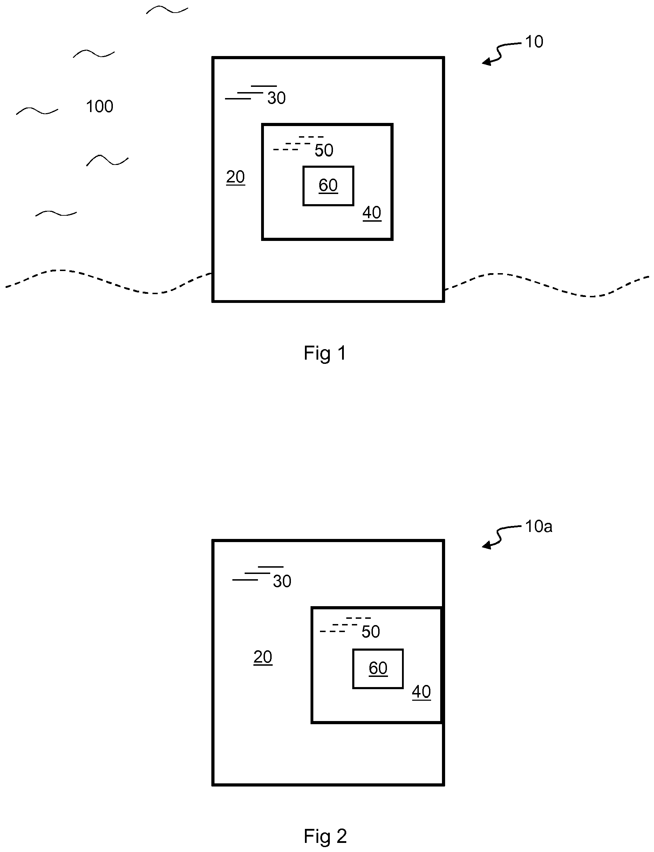

Figures 1-8 show different examples of realizations of the general concept of the present invention, which is based on the idea of a subsea unit 10, 10a, 10b, 10c, 10d, 10e, 10f, 10g with a cooling reservoir 20 and a component reservoir 40 containing different liquids 30, 50. The component reservoir 40 contains a heat generating component 60 and first liquid 50 which has suitable electrical insulating properties, hereinafter referred to as the dielectric liquid 50. The cooling reservoir 20 contains a second liquid 30 which has suitable heat transfer properties, hereinafter referred to as the cooling liquid 30.

According to all examples of this disclosure, the heat generating component 60 can be surrounded by a dielectric liquid 50 of very high electrically insulating properties. The component reservoir 40 can be made very compact, while a proper electrical insulation of the component 60 is still ensured. The component reservoir 40 is in thermal conductive connection with the cooling reservoir 20 which means that heat can be transferred to the cooling reservoir 20 by means of conduction, convection and radiation. The dielectric liquid 50 will be quickly heated throughout the compact component reservoir 40 at start-up, quickly reducing the viscosity of the first liquid, and thus allowing efficient cooling shortly after a cold start.

The cooling reservoir 20 can be furnished with a cooling liquid 30 of very high thermal conductivity and specific heat, so that the heat from the component reservoir 40 is effectively transported to the surrounding sea water 100. The cooling liquid 30 can be one of low viscosity, especially one of low viscosity at lower temperatures (close to or below 0 °C), further ensuring efficient cooling, especially after a cold start. The dynamic viscosity (µ) of the cooling liquid may be approximately 0.6 mPa·s at 40 degrees Celsius, and approximately 1.5 mPa·s at 5 degrees Celsius. As a comparison, the dynamic viscosity of the dielectric liquid at the same temperatures may be 10 to at least 50 times as high. Also, the second liquid can be one of high thermal expansion coefficient. The volumetric thermal expansion coefficient (αᵥ) of the cooling liquid may be approximately 4·10⁻²/K at 40 degrees Celsius.

These general advantages apply to all examples described below. Additional advantages of the specific examples will be pointed out in the following.

An example of a realization of the present invention is schematically shown in figure 1. A cross-section of a subsea unit 10 in form of a cubicle is disclosed with one side resting on the sea bed and five sides surrounded by sea water 100. In practise, the subsea unit may have another geometrical shape, for instance a circular cylindrical shape. A heat generating component 60 is shown in the centre of the subsea unit 10. For instance, the heat generating component 60 may be a semiconductor component such as an insulated-gate bipolar transistor (IGBT) 60. The heat generating component 60 is arranged in the component reservoir 40 which is filled with the dielectric liquid 50. The component reservoir 40 is arranged in the cooling reservoir 20 which is filled with the cooling liquid 30. The heat generating component 60 is completely surrounded by the dielectric liquid 50, and the component reservoir 40 is completely surrounded by the cooling liquid 30. This means that all heat generated in the heat generating component 60 will be dissipated to the dielectric liquid 50 and from there to the cooling liquid 30 and then finally to the surrounding sea water 100.

An advantage of such a subsea unit 10 is that the outer surface of the unit 10 can be kept relatively low. The heat from the heat generating component 60 is evenly dissipated to the sea water 100 from the outer surface of the unit 10. There are no local "hot spots" promoting growth of sea life or scale deposit.

The subsea unit 10a of figure 2 differs from the one of figure 1 in that the component reservoir 40 is attached to a side wall of the cooling reservoir 20. Thereby, the component reservoir 40 is in thermal conductive connection with said side wall, and also in thermal conductive connection with the surrounding sea water 100. In other words, the component reservoir 40 is in thermal conductive connection with an outer wall of the subsea unit 10a.

An advantage of this subsea unit 10a is that heat dissipation from the component reservoir 40 to the surrounding sea water is improved owing to the thermal conductive connection between the component reservoir 40 and the outer wall of the subsea unit 10a.

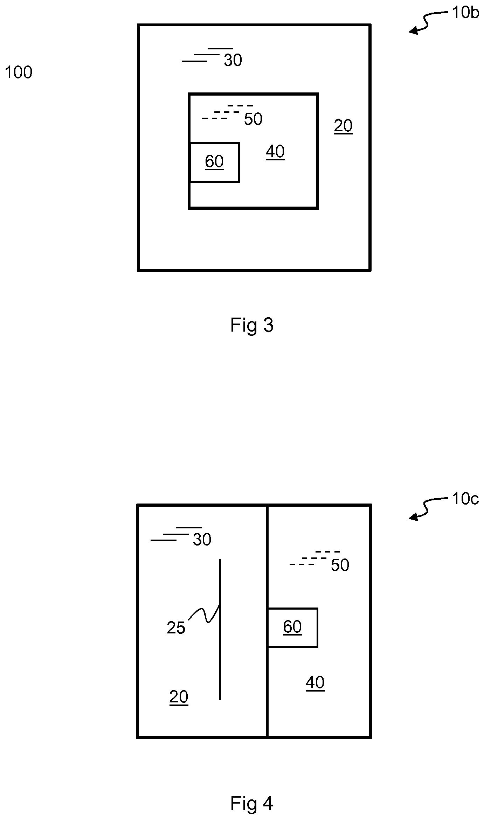

The subsea unit 10b of figure 3 differs from the one of figure 1 in that the heat generating component 60 is attached to a side wall of the component reservoir 40. The component 60 is in thermal conductive connection with the cooling reservoir 20. Although not shown, there may be a thermally conducting yet electrically insulating layer arranged between the heat generating component 60 and the wall of the component reservoir 40. Such a layer allows the heat generating component 60 and the wall of the component reservoir to be at different electrical potentials.

An advantage of the subsea unit 10b of figure 3 is that the heat of the heat generating component 60 can be efficiently conducted to the cooling reservoir 20.

Figure 4 discloses a subsea unit 10c where the component reservoir 40 and the cooling reservoir 20 are instead arranged side by side. This means that the component reservoir 40 is in thermal conductive connection with an outer wall of the subsea unit 10c. The heat generating component 60 is in thermal conductive connection with a separating wall between the cooling reservoir 20 and the component reservoir 40, and is thus in thermal conductive connection with the cooling reservoir 20. As can be seen in figure 4, said separating wall is a wall of the component reservoir 20. The heat generating component 60 may be attached to the wall of the component reservoir 20. A thermally conducting yet electrically insulating layer may be arranged between the heat generating component 60 and the wall of the cooling reservoir 20 where the heat generating component 60 is attached. The heat from the heat generating component 60 is chiefly dissipated through the cooling reservoir 20 to the surrounding water 100, but heat is also transferred directly from the component chamber 40 to the surrounding water 100.

The cooling offered by the cooling chamber 20 and by the component chamber 40 can be improved by natural convention flows within said chambers 20, 40. Natural convention will also occur in the examples 10, 10a, 10b described above, but the side-by-side configuration of figure 4 is particularly encouraging such flows. The natural convection will be driven by the heat generating component 60, particularly if, as in this example, if the heat generating component 60 is located in thermal conductive connection with a side wall of the respective chambers 20, 40. The natural convection of the cooling liquid 30 can be improved by the addition of an optional flow directing structure 25 in the cooling reservoir 20. Such a flow directing structure may be a vertical plate 25 arranged within the cooling reservoir, leaving openings both at the upper and the lower ands of the plate such that the cooling liquid may flow around the plate 25. The flow directing structure 25 will guide the cooling liquid 20 upwards on the side of the flow directing structure where the heat generating component 60 is located (right side of plate 25 in figure 4), and will guide the cooling liquid downwards (left side) on the side of the flow directing 25 structure where the cooling liquid 30 is cooled by the surrounding sea water 100.

Advantages of the subsea unit 10c of figure 4 include efficient cooling of the component reservoir 20 owing to the thermal conductive connection between the component reservoir and the surrounding water 100. The cooling is further improved by the natural convective flows of the cooling liquid 30 and of the dielectric liquid 50.

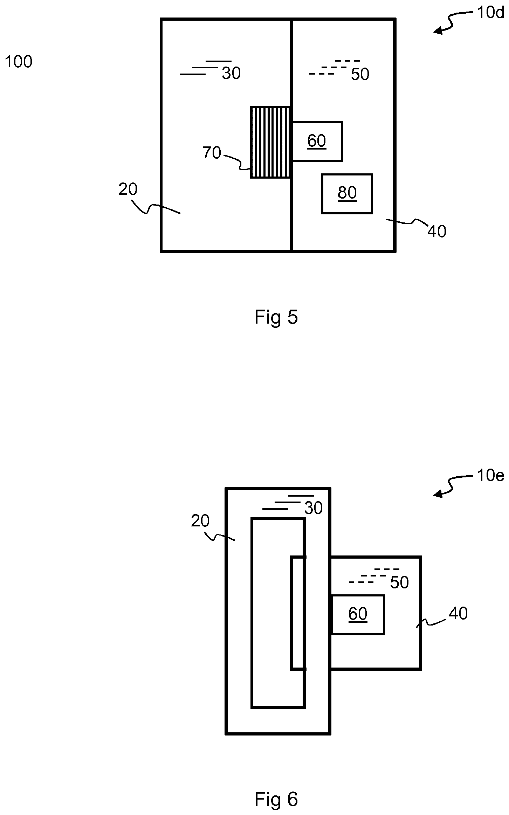

Figure 5 shows a subsea unit 10d similar to that of figure 4 with the addition of an inner heat exchanging device 70. The inner heat exchanging device 70 is arranged in the cooling reservoir 20 and is in thermal conductive connection with the inner heat exchanging device 70. More precisely, the inner heat exchanging device 70 and the heat generating component 60 are arranged in thermal conductive connection with either side of the separating wall which separates the two reservoirs 20, 40. Thermally conducting yet electrically insulating layers may be arranged between the heat generating component 60 and/or the inner heat exchanging device 70 and the separating wall. The inner heat exchanging device 70 is in this example embodied as a heat sink 70. In use, heat generated in the heat generating component 60 is conducted through the separating wall and conducted into the heat sink 70 from where the heat is dissipated to the cooling liquid 30. Preferably, the heat sink 70 comprises a metal body with fins (not shown in detail) which protrude from a base of the metal body into the cooling reservoir, where the fins efficiently dissipate the heat to the cooling liquid 30.

Figure 5 further includes a second heat generating component 80, which is arranged out of thermal conductive connection with any wall of the subsea unit 10d. The second heat generating component 80 is one which generates less heat than the aforementioned, or first, heat generating component 60 which is arranged in thermal conductive connection with the separating wall. The second heat generating component 80 may be an electrical component such as a capacitor. Heat generated in the capacitor 80 will be dissipated to the dielectric liquid 50, which means that the capacitor 80 will not be as efficiently cooled as the IGBT 60. The convective flow within the component reservoir will enhance the cooling of the capacitor 80. The subsea unit 10d of figure 5 may also be furnished with a flow directing structure 25 as described in connection with figure 4.

The heat sink 70 improves the heat transfer from the heat generating component to the cooling liquid 30. Another advantage of the subsea unit 10d of figure 5 is that not only a first heat generating component 60 but also a second heat generating component 80 can be electrically insulated and cooled.

Figure 6 discloses a subsea unit 10e where cooling reservoir 20 has the form of a loop. The cooling reservoir 20 comprises upper and lower horizontal legs, and two vertical legs. The leg portions that form the cooling reservoir are each surrounded by sea water, apart from where the leg is in thermal conductive connection with the component reservoir 40. The cooling reservoir 20 may have an O-shape. The cooling reservoir 20 has a tubular cross-section (not shown), for instance a circular, square or rectangular cross-section. In the present example, the loop-shaped cooling reservoir 20 passes straight through the component reservoir 40. This means that the component reservoir 40 has an upper and a lower opening, both adapted to the tubular cross-section of the cooling reservoir 20, through which openings the cooling reservoir enters and exits the component reservoir. As can be understood from figure 6, the dielectric liquid 50 of the component reservoir 40 can efficiently transfer heat to the cooling reservoir 20, more precisely to the portion of the cooling reservoir 20 that is located within the component reservoir 40. The dielectric liquid 50 surrounds the portion of the cooling reservoir 20 that is located within the component reservoir 40. In addition, heat from the component reservoir 40 can be conducted directly to the surrounding sea water 100.

Since the heat generating component 60 is in thermal conductive connection with the cooling reservoir 20, the heat generated in the component 60 is efficiently conducted to the cooling liquid 30. Heat from the dielectric liquid 50 is also transferred to the cooling liquid 30. Thereby, the cooling liquid 30 is stimulated to move upwards in the portion of the cooling reservoir 20 that is located within the component reservoir 40. The rest of the cooling reservoir 20 is cooled by the surrounding sea water 100, which means that the cooling liquid 30 outside the component reservoir will be stimulated to move downwards. Thus, circular flow of the cooling liquid will be created. In the subsea unit 10e of figure 6, said flow will be in the counter-clockwise direction.

In the present example, the rightmost vertical leg of the cooling reservoir 20 is longer than the height component reservoir 40. This means that the cooling liquid within the upper and lower vertical portions outside the component reservoir 40 will be cooled by the surrounding seawater, which counteracts the convective flow. However, the subsea unit 10e may be configured such that the height of the component reservoir 40 is essentially equal to the length of the vertical portion of the cooling reservoir 20 that passes through the component reservoir 40. Alternatively, thermal insulation can be provided around said upper and lower vertical portions.

Even though not disclosed in any one of the present examples, a loop-shaped cooling reservoir 20 may be arranged on a side of a component reservoir 40, but still in thermal conductive connection with the component reservoir 40. Such a cooling reservoir 20 would hence not pass through the component reservoir 40, but be arranged adjacent the component reservoir 40.

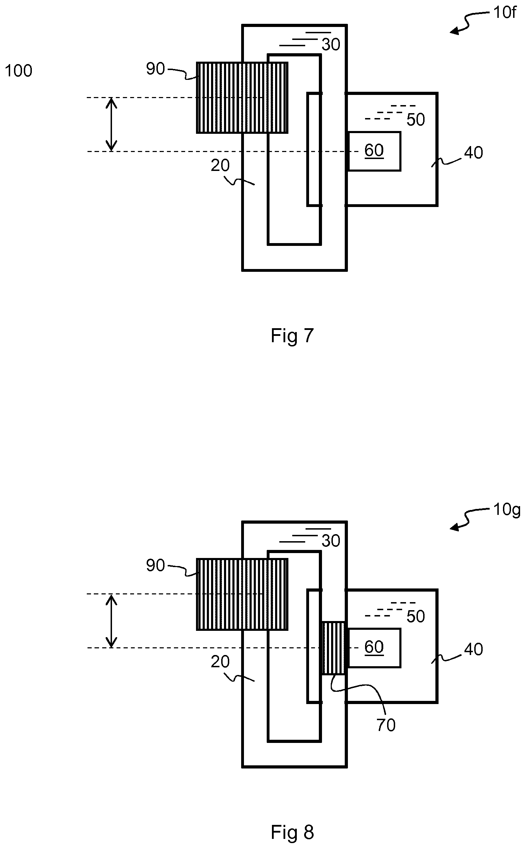

The subsea unit 10f of figure 7 differs from the one of figure 6 by the addition of an outer heat exchanging device 90. The outer heat exchanging device 90 is in this example embodied as a heat exchanger 90. The heat exchanger may be a bundle of tubes, or of another construction that provides a large contact area between the cooling liquid 30 within the heat exchanger and the sea water 100 outside the heat exchanger. Through the wall of the heat exchanger 90, there is a thermal conductive connection between the cooling liquid 30 and the surrounding water 100.

The outer heat exchanging device 90 improves the cooling reservoir's 20 ability to dissipate the heat absorbed from the component reservoir 40 and from the heat generating component 60 to the surrounding water. Thereby, the outer heat exchanging device 90 enhances the convective flow within the cooling reservoir 20.

As is indicated by the double-arrow in figure 7, the outer heat exchanging device 90 is arranged vertically higher than the component reservoir 40, which enhances the convective flow. By vertically higher is meant that the centre of gravity of the volume of the cooling liquid 30 within the outer heat exchanging device 90 is arranged vertically higher than the centre of gravity of the volume of the dielectric liquid 50 within component reservoir 40.

The subsea unit 10g of figure 8 differs from the one of figure 7 by the addition of an inner heat exchanging device 70. The inner heat exchanging device 70 may be a heat sink 70, as has already been described above in connection with figure 5.

The inner heat exchanging device 70 improves the cooling reservoir's 20 ability to absorb heat from the heat generating component 60. Thereby, the inner heat exchanging device 70 enhances the convective flow within the cooling reservoir 20. A particularly effective flow can be obtained by providing both inner and outer heat exchanging devices 70, 90, as disclosed in figure 8. However, a subsea unit with only an inner heat exchanging device 70 is not excluded.

As is indicated by the double-arrow in figure 8, the outer heat exchanging device 90 is arranged vertically higher than the inner heat exchanging device 70, which enhances the convective flow. The centre of gravity of the volume of the cooling liquid 30 within the outer heat exchanging device 90 is arranged vertically higher than the centre of gravity of the volume of the cooling liquid 30 within the inner heat exchanging 70.

In the above described subsea units 10, 10a, 10b, 10c, 10d, 10e, 10f the cooling liquid 30 is preferably one of low viscosity and of high thermal expansion coefficient, both said properties have a positive effect on the convective flow of the cooling liquid.

The above subsea units form examples of realizations of the present invention within the scope of the appended independent claims. A number of variations are possible without departing the claimed scope. The inner heat exchanging devices 70 included in the subsea units 10d, 10g of figure figures 5 and 8 can also be incorporated in the unit 10b of figure 3. Also, one or more second heat generating component(s) 80, as shown in the subsea unit 10d of figure 5, can also be included in any one of the other exemplified subsea units 10, 10a, 10b, 10c, 10e, 10f, 10g. The heat generating component 60 and a structure to which it dissipates heat by conduction can be kept at different electrical potentials by arranging an electrically insulating and thermally conducting layer between the heat generating component and said structure.

The dielectric liquid is chosen primarily based on its electrical insulating properties whereas the cooling liquid is chosen primarily based on its heat transfer properties. The dielectric liquid surrounds the heat generating component which typically does not have a liquid tight casing, which entails that the dielectric liquid may contact live, or current carrying, equipment such as wires and electric/electronic components. The cooling liquid, on the other hand, can be kept out of contact with live equipment. In the figures 1-8, the dielectric liquid 50 is indicated by three dashed lines and the dielectric liquid 30 is indicated by thee solid lines.

A general concept on which the invention is based, is providing a subsea unit comprising a dielectric liquid 50, a cooling liquid 30 and a heat generating component 60. The heat generating component 60 is arranged in the dielectric liquid 50, and the dielectric liquid 50 and the cooling liquid 30 are in thermal conductive connection with each other. Heat which in operation is dissipated from the heat generating component 60 can be absorbed by the dielectric liquid 50 and transferred to the cooling liquid 20 and then to the ambient sea water 100. As has been described, the heat generating component 60 can in addition be arranged in thermal conductive connection with the cooling liquid 20.

In short, the operation of the subsea unit 10, 10a, 10b, 10c, 10d, 10e, 10f, 10g entails heat being generated in the heat generating component 60 and dissipated to the dielectric liquid 50, to the cooling liquid 30 and finally to the surrounding sea water 100. If the heat generating component 60 is in thermal conductive connection with the cooling reservoir 20, heat of the heat generating component 60 is also dissipated directly to the cooling liquid 30.

In all examples, the component reservoir 40 and the cooling reservoir 20 are separate and liquid-tight reservoirs. There is no passage allowing the dielectric liquid 50 and the cooling liquid 30 to mix, or allowing ingress of the surrounding sea water 100 to mix with any of these liquids 30, 50. Even though not shown in any of the figures, the subsea unit may comprise more than one component reservoir 40, such that two or more component reservoirs 40 are cooled by the same cooling reservoir 20.

Further, in all examples, the heat generating component 60 is arranged out of thermal conductive connection with all outer walls of the subsea unit. The heat generating component 60 is arranged in thermal conductive connection with the dielectric liquid 50. The cooling reservoir 20 is arranged in thermal conductive connection with the surrounding sea water 100.

The schematic figures of the present disclosure do not include wirings or penetrators for such wirings. Foundations and support structures for the subsea unit are also left out.

## Claims

1. A subsea unit (10) comprising
a component reservoir (40) containing a heat generating component (60) and a first liquid (50), and
a cooling reservoir (20) containing a second liquid (30) and being arranged in thermal conductive connection with the component reservoir (40), wherein the cooling reservoir (20) is loop-shaped, thereby promoting a convective flow of the second liquid (30) in use, wherein the cooling reservoir (20) comprises an outer heat exchanging device (90) arranged in direct contact with the water (100) surrounding the subsea unit (10), in order to promote the heat transfer from the second liquid (30) to the surrounding water (100) in use,
said first liquid (50) being one which has suitable electrical insulating properties in order to electrically insulate the heat generating component (60), and
said second liquid (30) being one which has suitable heat transfer properties in order to provide cooling to the component reservoir (40), **characterised in that** the outer heat exchanging device (90) is arranged vertically higher than the component reservoir (40), in order to further promote the convective flow of the second liquid (30) in use,
wherein the component reservoir (40) and the cooling reservoir (20) is pressure compensated, whereby the pressure inside the component reservoir (40) and the pressure inside the cooling reservoir (20) correspond to the pressure of the water (100) surrounding the subsea unit (10).

2. The subsea unit (10) of claim 1, wherein the second liquid (30) has better heat transfer properties than the first liquid (50).

3. The subsea unit (10) of claims 1 or 2, wherein the second liquid (30) mainly consists of non-deionized water.

4. The subsea unit (10) of any previous claim, wherein the first liquid (50) has better electrical insulating properties than the second liquid (30).

5. The subsea unit (10) of any previous claim, wherein the first liquid (50) is transformer oil, ester, purified water or a combination thereof.

6. The subsea unit (10; 10b) of any previous claim, wherein the component reservoir (40) is not arranged in thermal conductive connection with an outer wall of the subsea unit (10).

7. The subsea unit (10a; 10c; 10d; 10e; 10f; 10g) of any one of claims 1-5, wherein the component reservoir (40) is arranged in thermal conductive connection with an outer wall of the subsea unit (10).

8. The subsea unit (10; 10a-10g) of any previous claim, wherein no heat generating component (60) is arranged in thermal conductive connection with an outer wall of the subsea unit (10).

9. The subsea unit (10b; 10c; 10d; 10e; 10f; 10g) of any previous claim, wherein the heat generating component (60) is arranged in thermal conductive connection with the cooling reservoir (20).

10. The subsea unit (10b; 10c; 10d) of any previous claim, wherein the heat generating component (60) is arranged in thermal conductive connection with an outer wall of the component reservoir (40).

11. The subsea unit (10; 10a; 10e; 10f; 10g) of any one of claims 1-7, wherein no heat generating component (60) is arranged in thermal conductive connection with an outer wall of the component reservoir (40).

12. The subsea unit (10d; 10g) of any previous claim, wherein the cooling reservoir (20) further contains an inner heat exchanging device (70) arranged in thermal conductive connection with the heat generating component (60), in order to promote the heat transfer from the heat generating component (60) to the second liquid (30) in use.

13. The subsea unit (10) of any previous claim, wherein the subsea unit (10) is a subsea converter (10) and the heat generating component (60) is an insulated-gate bipolar transistor.

14. Use of the subsea unit (10) of any previous claim in a deepwater subsea environment, at a depth greater than 1000 m.

## Patentansprüche

1. Unterseeeinheit (10), die Folgendes umfasst:
einen Komponentenbehälter (40), der eine Wärmeerzeugungskomponente (60) und eine erste Flüssigkeit (50) enthält, und
einen Kühlbehälter (20), der eine zweite Flüssigkeit (30) enthält und in einer wärmeleitfähigen Verbindung mit dem Komponentenbehälter (40) angeordnet ist, wobei der Kühlbehälter (20) schleifenförmig ist, wodurch bei Verwendung eine Konvektionsströmung der zweiten Flüssigkeit (30) gefördert wird, wobei der Kühlbehälter (20) eine äußere Wärmetauschervorrichtung (90) umfasst, die in direktem Kontakt mit dem Wasser (100), das die Unterseeeinheit (10) umgibt, angeordnet ist, um bei Verwendung die Wärmeübertragung von der zweiten Flüssigkeit (30) auf das umgebende Wasser (100) zu fördern,
wobei die erste Flüssigkeit (50) eine Flüssigkeit ist, die geeignete elektrisch isolierende Eigenschaften aufweist, um die Wärmeerzeugungskomponente (60) elektrisch zu isolieren, und
wobei die zweite Flüssigkeit (30) eine Flüssigkeit ist, die geeignete Wärmeübertragungseigenschaften aufweist, um eine Kühlung für den Komponentenbehälter (40) bereitzustellen,
**dadurch gekennzeichnet, dass** die äußere Wärmetauschervorrichtung (90) vertikal höher als der Komponentenbehälter (40) angeordnet ist, um bei Verwendung die Konvektionsströmung der zweiten Flüssigkeit (30) weiter zu fördern,
wobei der Komponentenbehälter (40) und der Kühlbehälter (20) druckausgeglichen sind, wodurch der Druck im Inneren des Komponentenbehälters (40) und der Druck im Inneren des Kühlbehälters (20) dem Druck des Wassers (100) entsprechen, das die Unterseeeinheit (10) umgibt.

2. Unterseeeinheit (10) nach Anspruch 1, wobei die zweite Flüssigkeit (30) bessere Wärmeübertragungseigenschaften als die erste Flüssigkeit (50) aufweist.

3. Unterseeeinheit (10) nach Anspruch 1 oder 2, wobei die zweite Flüssigkeit (30) hauptsächlich aus nicht deionisiertem Wasser besteht.

4. Unterseeeinheit (10) nach einem der vorhergehenden Ansprüche, wobei die erste Flüssigkeit (50) bessere elektrisch isolierende Eigenschaften als die zweite Flüssigkeit (30) aufweist.

5. Unterseeeinheit (10) nach einem der vorhergehenden Ansprüche, wobei die erste Flüssigkeit (50) ein Transformatoröl, ein Ester, gereinigtes Wasser oder eine Kombination davon ist.

6. Unterseeeinheit (10; 10b) nach einem der vorhergehenden Ansprüche, wobei der Komponentenbehälter (40) nicht in einer wärmeleitfähigen Verbindung mit einer Außenwand der Unterseeeinheit (10) angeordnet ist.

7. Unterseeeinheit (10a; 10c; 10d; 10e; 10f; 10g) nach einem der Ansprüche 1-5, wobei der Komponentenbehälter (40) in einer wärmeleitfähigen Verbindung mit einer Außenwand der Unterseeeinheit (10) angeordnet ist.

8. Unterseeeinheit (10; 10a-10g) nach einem der vorhergehenden Ansprüche, wobei keine Wärmeerzeugungskomponente (60) in einer wärmeleitfähigen Verbindung mit einer Außenwand der Unterseeeinheit (10) angeordnet ist.

9. Unterseeeinheit (10b; 10c; 10d; 10e; 10f; 10g) nach einem der vorhergehenden Ansprüche, wobei die Wärmeerzeugungskomponente (60) in einer wärmeleitfähigen Verbindung mit dem Kühlbehälter (20) angeordnet ist.

10. Unterseeeinheit (10b; 10c; 10d) nach einem der vorhergehenden Ansprüche, wobei die Wärmeerzeugungskomponente (60) in einer wärmeleitfähigen Verbindung mit einer Außenwand des Komponentenbehälters (40) angeordnet ist.

11. Unterseeeinheit (10; 10a; 10e; 10f; 10g) nach einem der Ansprüche 1-7, wobei keine Wärmeerzeugungskomponente (60) in einer wärmeleitfähigen Verbindung mit einer Außenwand des Komponentenbehälters (40) angeordnet ist.

12. Unterseeeinheit (10d; 10g) nach einem der vorhergehenden Ansprüche, wobei der Kühlbehälter (20) ferner eine innere Wärmetauschervorrichtung (70) enthält, die in einer wärmeleitfähigen Verbindung mit der Wärmeerzeugungskomponente (60) angeordnet ist, um bei Verwendung die Wärmeübertragung von der Wärmeerzeugungskomponente (60) auf die zweite Flüssigkeit (30) zu fördern.

13. Unterseeeinheit (10) nach einem der vorhergehenden Ansprüche, wobei die Unterseeeinheit (10) ein Unterseeumsetzer (10) ist und die Wärmeerzeugungskomponente (60) ein bipolarer Transistor mit isoliertem Gate ist.

14. Verwendung der Unterseeeinheit (10) nach einem der vorhergehenden Ansprüche in einer Tiefenwasser-Unterseeumgebung bei einer Tiefe, die größer als 1000 m ist.

## Revendications

1. Unité sous-marine (10) comprenant
un réservoir de composant (40) contenant un composant générant de la chaleur (60) et un premier liquide (50), et
un réservoir de refroidissement (20) contenant un deuxième liquide (30) et étant agencé en connexion thermoconductrice avec le réservoir de composant (40), le réservoir de refroidissement (20) étant en forme de boucle, favorisant ainsi un écoulement convectif du deuxième liquide (30) à l'usage, le réservoir de refroidissement (20) comprenant un dispositif d'échange de chaleur extérieur (90) agencé en contact direct avec l'eau (100) entourant l'unité sous-marine (10), afin de favoriser le transfert de chaleur du deuxième liquide (30) à l'eau environnante (100) à l'usage,
ledit premier liquide (50) en étant un qui a des propriétés électriques isolantes appropriées afin d'isoler électriquement le composant générant de la chaleur (60), et
ledit deuxième liquide (30) en étant un qui a des propriétés de transfert de chaleur appropriées afin d'assurer le refroidissement du réservoir de composant (40),
**caractérisée en ce que** le dispositif d'échange de chaleur extérieur (90) est agencé verticalement plus haut que le réservoir de composant (40), afin de favoriser encore plus l'écoulement convectif du deuxième liquide (30) à l'usage,
le réservoir de composant (40) et le réservoir de refroidissement (20) étant compensés en pression, moyennant quoi la pression à l'intérieur du réservoir de composant (40) et la pression à l'intérieur du réservoir de refroidissement (20) correspondent à la pression de l'eau (100) entourant l'unité sous-marine (10).

2. Unité sous-marine (10) de la revendication 1, dans laquelle le deuxième liquide (30) a de meilleures propriétés de transfert de chaleur que le premier liquide (50).

3. Unité sous-marine (10) des revendications 1 ou 2, dans laquelle le deuxième liquide (30) consiste principalement en de l'eau non déionisée.

4. Unité sous-marine (10) d'une quelconque revendication précédente, dans laquelle le premier liquide (50) a de meilleures propriétés électriques isolantes que le deuxième liquide (30).

5. Unité sous-marine (10) d'une quelconque revendication précédente, dans laquelle le premier liquide (50) est de l'huile pour transformateur, un ester, de l'eau purifiée ou une combinaison de ceux-ci.

6. Unité sous-marine (10 ; 10b) d'une quelconque revendication précédente, dans laquelle le réservoir de composant (40) n'est pas agencé en connexion thermoconductrice avec une paroi extérieure de l'unité sous-marine (10).

7. Unité sous-marine (10a ; 10c ; 10d ; 10e ; 10f ; 10g) de l'une quelconque des revendications 1 à 5, dans laquelle le réservoir de composant (40) est agencé en connexion thermoconductrice avec une paroi extérieure de l'unité sous-marine (10).

8. Unité sous-marine (10 ; 10a-10g) d'une quelconque revendication précédente, dans laquelle aucun composant générant de la chaleur (60) n'est agencé en connexion thermoconductrice avec une paroi extérieure de l'unité sous-marine (10).

9. Unité sous-marine (10b ; 10c ; 10d ; 10e ; 10f ; 10g) d'une quelconque revendication précédente, dans laquelle le composant générant de la chaleur (60) est agencé en connexion thermoconductrice avec le réservoir de refroidissement (20).

10. Unité sous-marine (10b ; 10c ; 10d) d'une quelconque revendication précédente, dans laquelle le composant générant de la chaleur (60) est agencé en connexion thermoconductrice avec une paroi extérieure du réservoir de composant (40).

11. Unité sous-marine (10 ; 10a ; 10e ; 10f ; 10g) de l'une quelconque des revendications 1 à 7, dans laquelle aucun composant générant de la chaleur (60) n'est agencé en connexion thermoconductrice avec une paroi extérieure du réservoir de composant (40).

12. Unité sous-marine (10d ; 10g) d'une quelconque revendication précédente, dans laquelle le réservoir de refroidissement (20) contient en outre un dispositif d'échange de chaleur intérieur (70) agencé en connexion thermoconductrice avec le composant générant de la chaleur (60), afin de favoriser le transfert de chaleur du composant générant de la chaleur (60) au deuxième liquide (30) à l'usage.

13. Unité sous-marine (10) d'une quelconque revendication précédente, l'unité sous-marine (10) étant un convertisseur sous-marin (10) et le composant générant de la chaleur (60) étant un transistor bipolaire à grille isolée.

14. Utilisation de l'unité sous-marine (10) d'une quelconque revendication précédente dans un environnement sous-marin en eau profonde, à une profondeur supérieure à 1000 m.
